Europäisches Patentamt

European Patent Office

Office européen des brevets

(11) Publication number: **0 104 079**
**B1**

## EUROPEAN PATENT SPECIFICATION

(45) Date of publication of patent specification: **23.08.89**

(51) Int. Cl.⁴: **H 01 L 23/48,** H 01 L 21/285

(21) Application number: **83305513.0**

(22) Date of filing: **20.09.83**

(54) Integrated circuit contact structure.

(30) Priority: **20.09.82 US 419677**

(43) Date of publication of application:
**28.03.84 Bulletin 84/13**

(45) Publication of the grant of the patent:
**23.08.89 Bulletin 89/34**

(84) Designated Contracting States:
**DE FR GB**

(56) References cited:
**GB-A-2 075 255**
**US-A-3 833 842**

**JOURNAL OF APPLIED PHYSICS, vol. 53, no.
10, October 1982, pages 6898-6905, American
Institute of Physics, New York, US; S.E.
BABCOCK et al.: "Titanium-tungsten contacts
to Si: The effects of alloying on schottky
contact and on silicide formation"**

**JOURNAL OF APPLIED PHYSICS, vol. 50, no.
10, October 1979, pages 6316-6320, American
Institute of Physics, New York, US; J.O.**

(73) Proprietor: **International Business Machines
Corporation
Old Orchard Road
Armonk, N.Y. 10504 (US)**

(72) Inventor: **Aboelfotoh, Mohamed Osama
4 Timberline Drive
Poughkeepsie New York 12603 (US)**
Inventor: **Tsang, Yuk Lun
St. George Ct., RD 7
Kingston New York 12401 (US)**

(74) Representative: **Richards, John Peter
IBM United Kingdom Limited Intellectual
Property Department Hursley Park
Winchester Hampshire SO21 2JN (GB)**

(56) References cited:

**OLOWOLAIE et al.: "Contact reaction between
Si and Pd-W alloy films"**

**SOLID STATE ELECTRONICS, vol. 19, 1976,
pages 493-494, Pergamon Press, GB; P.C.
PAREKH et al.: "Behavior of various silicon
schottky barrier diodes under heat treatment"**

Courier Press, Leamington Spa, England.

(56) References cited:

**PATENTS ABSTRACTS OF JAPAN, vol. 5, no. 186 (E-84) 858r, 25th November 1981; & JP - A - 56 111 264 (KOGYO GIJUTSUIN) 02-09-1981**

**THE ELECTROCHEMICAL SOCIETY INC., SPRING MEETING, 11th-16th May 1975, Toronto, CA, pages 248-249, Electrochemical Society Inc., Princeton, New York, US; Extended Abstracts of Battery-Electronics Divisions, vol. 75-1, abstract no. 108; J.M. HARRIS et al.: "Study of Ti-W metalization on Si"**

## Description

The present invention relates to an integrated circuit ohmic contact structure.

In semiconductor devices, such as insulated gate field effect transistors, the source and drain electrodes usually comprise a low melting point metal such as aluminium, which has been deposited on the surface of the source and drain regions making ohmic contact therewith. While aluminium may be satisfactory for this purpose in devices that have relatively deep source and drain regions, i.e. depths substantially exceeding one micron, it has not proven satisfactory for making ohmic contact to source and drain regions which are very shallow, such as 0.5 micron or less in depth. Specifically, in fabricating the metal electrode, the aluminium is first deposited on the surface of the source and drain regions, and then subjected to a heat treatment at a temperature ranging from 400°C to 500°C to ensure an electrical connection. During this heat treatment, aluminium diffuses through the shallow depth of the semiconductor regions and thereby increases the leakage current, finally causing the underlying semiconductor junction to be shortcircuited. This destruction of the semiconductor junction is termed in the art "junction spiking".

The connection of a metal electrode to a semiconductor region formed in the surface of a semiconductor body or substrate of opposite conductivity type is generally performed by selectively etching away an insulating layer, which protects the surface of the surrounding semiconductor body and the PN junction, to form a contact window exposing the surface of the region. Electrode material, such as aluminium, is then deposited on the surface of the semiconductor region through the contact window. The formation of the contact window in the insulating layer is provided in accordance with well-known lithographic techniques. The formation of the semiconductor region in the semiconductor body is provided by using a diffusion mask having a window at a predetermined location, which is also formed in accordance with conventional lithographic techniques. Ideally, it is desired that the contact and diffusion windows be precisely aligned at the contact locations with a specified size. However, because some misalignment of the mask patterns for forming the contact window and diffusion window is unavoidable, and due to over-etching, the contact window frequently exposes a portion of the semiconductor body. As a result, in forming the aluminium layer, shortcircuiting of the underlying semiconductor junction occurs irrespective of junction spiking. These problems are associated with mask misalignment and over-etching are inherent to the lithographic techniques, and because of these problems, an increase in density of integrated circuit elements becomes difficult.

Certain methods for making contacts to shallow semiconductor regions have been proposed in the art to overcome the above-mentioned disadvantages, but none have proven satisfactory. In G.B. Patent No. 2,075,255 a method for providing contacts to shallow semiconductor regions is described which includes forming a semiconductor layer of the same conductivity type as that of a semiconductor region on the portion of the semiconductor body exposed through a contact window in an insulating layer covering the surface of the semiconductor body, and forming a metal-semiconductor alloy layer electrically connected to the semiconductor layer described above. Therefore, even when the contact window exposes a portion of the semiconductor body as a result of mask misalignment, the portion exposed by the contact window is of the same conductivity type as that of the semiconductor region because of the presence of the semiconductor layer. Consequently, no shortcircuiting of the PN semiconductor junction by the interconnecting metalsemiconductor alloy layer takes place. However, while junction spiking may not occur during heat treating processes at a temperature range between 400°C to 500°C, device failure by current leakage and junction spiking does occur at positively biased contacts.

Other methods for making an ohmic contact to a shallow semiconductor region have also been described in the art (see U.S. Patents 3,906,540 and 4,141,022) which include depositing a first layer of a refractory metal, such as platinum, palladium or nickel, which form a silicide alloy with the silicon surface on which it is deposited, and then depositing a second layer of a refractory metal, such as molybdenum or titanium, on the refractory metal silicide layer. This second layer serves as a barrier to prevent the diffusion through the semiconductor regions of the subsequently deposited interconnect metal, such as aluminium. The problem with this solution for an ohmic contact to a shallow semiconductor region is that during the formation of the silicide alloy, a significant amount of silicon is consumed from the silicon substrate and, as a result, the depth of the semiconductor region and the dopant concentration therein are altered, thus resulting in adverse effects on device performance.

Accordingly, an object of the present invention is to provide an improved method for fabricating an electrically stable low resistance ohmic contact to a shallow semiconductor region, which result in improved electrical characteristics and increased yield for the resulting semiconductor devices. It is particularly desirable to provide a method which will improve the stability of a positively biased contact to a shallow semiconductor region. This improvement in the stability of the positively biased contact, in turn, improves the electrical characteristics and increase the yield of field effect integrated circuit structures.

In accordance with the present invention there is provided an integrated circuit ohmic contact structure for a shallow semiconductor region provided in the surface of, and forming a PN junction with, a surrounding silicon semiconductor body, characterised by an insulating layer formed on the surface of the silicon semiconductor body, the insulating layer having a contact window exposing the shallow semiconductor region, a polycrystalline silicon layer formed in the contact window and overlapping the edges thereof, the polycrystalline silicon layer being doped with an impurity of the same conductivity type as that of the semiconductor region, a plurality of layers of refractory metal formed on the polycrystalline silicon layer, and a layer of interconnect metal formed on the upper surface of the refractory metal layers.

Preferably, two layers of refractory metal are provided, the first being a titanium/tungsten alloy comprising 10 to 30 percent by weight tungsten which serves to provide an electrically stable interface with the doped polycrystalline semiconductor layer. The first refractory metal alloy layer also serves to promote strong adhesion between the interconnecting aluminium layer and the doped polycrystalline semiconductor layer. A second layer of a refractory metal, such as tantalum, tungsten or a refractory metal alloy such as titanium/tungsten comprising at least 70 percent by weight tungsten is then formed on the first refractory metal alloy layer, and functions to prevent current leakage and junction spiking, particularly at positively biased contacts.

Since the method of the present invention requires neither the formation of metal silicide nor the consumption of any significant amount of silicon from the silicon substrate, a low resistance ohmi contact to a shallow semiconductor region is formed with improved electrical characteristics and increased manufacturing yield of the resulting semiconductor device.

Embodiments of the invention will now be described with reference to the accompanying drawings, in which:

Figures 1 to 7 are cross-sectional views illustrating a sequence of process steps for fabricating a multilayer ohmic contact structure in accordance with the present invention, and

Figures 8 to 14 are cross-sectional views illustrating a sequence of process steps for fabricating an insulated gate field effect transistor incorporating a contact structure in accordance with the present invention.

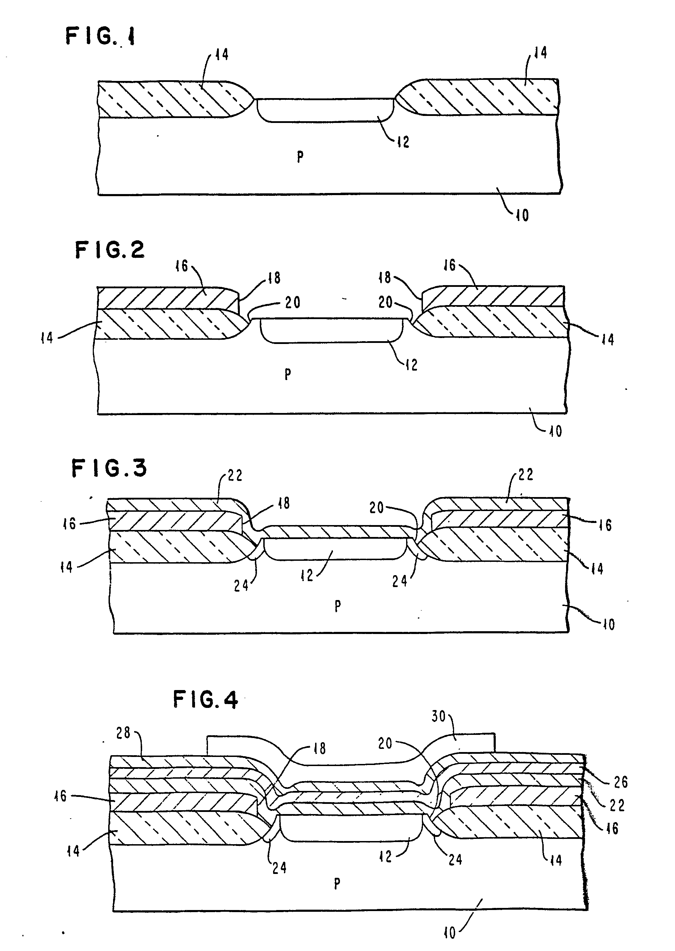

Referring now to the drawings, Figures 1 to 7 illustrate an improved method for fabricating a low resistance ohmic contact to a semiconductor region forming a shallow PN junction with a surrounding semiconductor body. Although the example described will be a multilayer contact structure to an N-type region formed in a P-type silicon body or substrate, a contact structure to a P-type region formed in an N-type silicon substrate can be fabricated by reversing the conductivity types throughout.

As shown in Figure 1, an N-type impurity such as arsenic is introduced into a P-type substrate 10 of monocrystalline silicon by ion implantation and a subsequent drive-in process to form an N+ region 12, such as the source or drain region of an N-channel transistor, with a depth of 0.5 micron or less and an impurity concentration of approximately $10^{19}$ atoms/cm³, The N+ region 12 is isolated from other integrated circuit device regions by a surrounding recessed isolation oxide region 14. The recessed oxide region 14 may be formed by any technique known in the art for fabricating such planar integrated circuit structures, e.g., the method described in the U.S. Patent 4,287,661.

Next, as shown in Figure 2, a silicon dioxide layer 16 with a thickness of approximately $5 \times 10^{-7}$ m (5000 Angstroms) is formed over the entire surface of the silicon substrate 10 including region 14 either by thermal oxidation at about 1000°C in a suitable oxygen, hydrogen chloride and steam atmosphere or by chemical vapour deposition. A contact window 18 for permitting interconnection of the N+ region 12 to other integrated circuit regions is then formed in the silicon dioxide layer 16 by conventional resist, lithography and etching techniques. As a result of mask misalignment and overetching of the silicon dioxide layer 16 during the formation of the contact window, problems inherent in lithographic techniques, the contact window 18 is not aligned with the N+ region 12, and therefore at least a portion 20 of the P-type silicon substrate 10 is exposed by the contact window 18. The resulting structure is shown in Figure 2.

Referring to Figure 3, a polycrystalline silicon layer 22 is deposited over the silicon dioxide layer 16 and into the contact window 18 to interface with the region 12 and the portion 20 of the P-type silicon substrate 10 exposed within the contact window by chemical vapour deposition, using silane in the temperature range of between about 600° to 1000°C. The preferred thickness of the polycrystalline silicon layer 22 is between about $3 \times 10^{-7}$ m and $5 \times 10^{-7}$ m (3000 and 5000 Angstroms). The polycrystalline silicon layer 22 is then doped with an N-type impurity such as phosphorus by thermal diffusion or ion implantation, the preferred doping level being between about $10^{19}$ and $10^{21}$ atoms/cm³.

By this step, the phosphorous dopants diffuse into the polycrystalline silicon layer 22 and are doped into the P-type silicon substrate 10 through the contact window 18, resulting in a formation of N+ regions 24 under the contact window 18. Therefore, even if the contact window 18 is not aligned with the N+ region 12, the metal layers to be formed do not cause a shortcircuit between the N+ region 12 and the P-type silicon substrate 10.

Referring now to Figure 4, a layer 26 of a refractory metal such as titanium/tungsten comprising 10 to 30 percent by weight tungsten and having a thickness of between about $5 \times 10^{-8}$ m and $2 \times 10^{-7}$ m (500 and 2000 Angstroms) is deposited over the polycrystalline silicon layer 22. Preferably, this is done using RF sputtering. The addition of a minor concentration of tungsten to the titanium serves to stabilise the electrical characteristics of the interface between layers 22 and 26 by effectively retarding the formation of metal silicides during the deposition of layer 26 and subsequent heat treating processes. As a result, only small amounts of silicon from the silicon substrate are consumed during the formation of the contact structure. Layer 26 also serves to promote strong adhesion between the interconnecting aluminium layer and the polycrystalline silicon layer 22. Atop layer 26 is deposited a second layer 28 of another refractory metal such as tantalum, tungsten or titanium/tungsten comprising at least 70 percent by weight tungsten. Layer 28 is also deposited by RF sputtering, although, if tantalum is used it may be deposited by evaporation. The preferred thickness of layer 28 is between about $5 \times 10^{-8}$ m and $2 \times 10^{-7}$ m (500 and 2000 Angstroms). Layer 28 serves to protect the PN junction against failure by current leakage and junction spiking, particularly at positively biased contacts. A layer 30 of a resist material having a thickness between $2 \times 10^{-6}$ m and $3 \times 10^{-6}$ m (20,000 and 30,000 Angstroms) is then deposited over refractory metal layer 28. Standard lithographic and masking techiques are used to provide a mask structure in the resist layer in an area lying directly above and slightly overlapping contact window 18 and layers 22, 26 and 28 are desired. The resulting structure is shown in Figure 4.

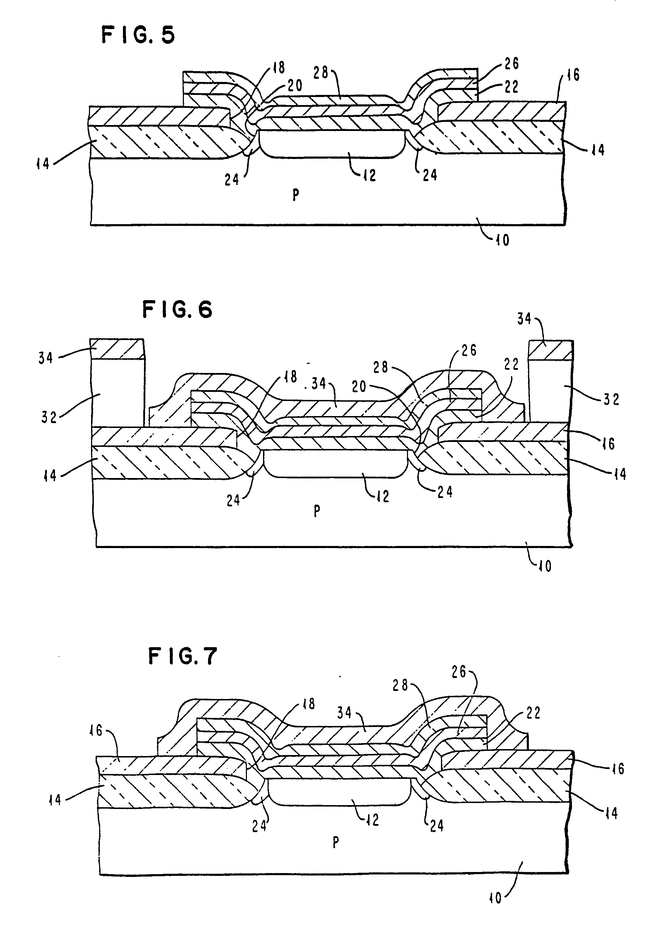

Referring now to Figure 5, layers 22, 26 and 28 are removed in undesired areas by suitable etching techniques using the remaining resist layer 30 as a mask. For example, if tantalum is used as refractory metal layer 28, it may be etched using techniques such as reactive ion etching or plasma etching in carbon tetrafluoride atmosphere. The titanium/tungsten layer 26 may be etched in hydrogen oxide ($H_2O_2$) at about 15°C to 35°C without chemically attacking the tantalum or silicon. The bottom N-type polycrystalline silicon layer 22 may also be etched using techniques such as reactive ion etching or plasma etching in a carbon tetrafluoride-hydrogen atmosphere. Thereafter, the remaining resist layer 30 is removed using conventional techniques.

Referring now to Figure 6, a second layer 32 of another resist material which will dissolve in n-methyl pyrolidone solution having a thickness of between $2 \times 10^{-6}$ m and $3 \times 10^{-6}$ m (20,000 and 30,000 Angstroms) is deposited over the entire surface of the silicon substrate 10. Conventional lithographic and masking techniques are then used to provide another mask structure in thd second resist layer in areas where a layer of interconnect metal .is not desired. A layer 34 of interconnect metal having a melting point lower than that of the refractory metal layers, such as aluminium of between $10 \times 10^{-7}$ m and $15 \times 10^{-7}$ m (10,000 and 15,000 Angstroms) in thickness, is then deposited over the entire surface of the silicon substrate 10, preferably by evaporation, as shown in Figure 6. Thereafter, the portions of the deposited layer 34 on top of the remaining second resist layer 32 are removed by dissolving the second resist layer 32 in n-methyl pyrodone solution at a temperature of about 85°C, leaving an interconnection pattern which forms the conductive interconnection paths between devices and regions in the integrated circuit.

The resulting structure is shown in Figure 7, which is subjected to a sintering process at a temperature of at least 400°C for at least 30 minutes to one hour. By this sintering step, good electrical connections between the interconnecting aluminium layer and the multilayer contact structure is ensured.

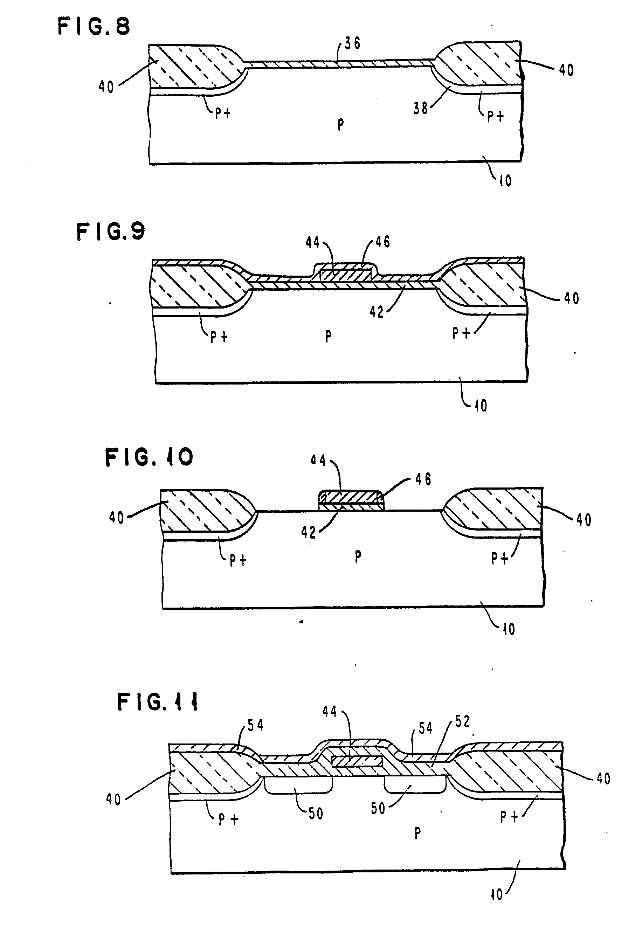

Referring now to Figures 8 to 14, there is shown a method for fabricating an integrated circuit insulated gate FET (field effect transistor) including a multilayer contact structure in accordance with the present invention. The embodiment herein described will be an N-channel transistor, although a P-channel transistor can be fabricated by simply reversing the P and N types.

A P-type substrate 10 of monocrystalline silicon is thermally oxidized at about 1000°C in a suitable oxygen and hydrogen chloride atmosphere to produce a silicon dioxide layer 36. A silicon nitride layer (not shown) is then deposited onto the silicon dioxide layer 36 by chemical vapour deposition, utilising an ambient of nitrogen, dichlorosilane and ammonia at a temperature of about 800°C. Conventional lithography processes are used to open the silicon substrate 10 through the silicon dioxide layer 36 and the silicon nitride layer, (not shown) in the region where it is desired to have a recessed oxide isolation structure. The silicon dioxide layer 36 and the silicon nitride layer may be removed by conventional etching techniques such as chemical wet etching, reactive ion etching or plasma etching. A P-type impurity such as boron is introduced into the silicon substrate 10 by diffusion or ion implantation to form the P+ region 38 in the area where the recessed silicon dioxide isolation is desired. The recessed oxide isolations region 40 is then formed in a suitable oxygen, hydrogen chloride and steam atmosphere at a temperature of about 950°C. The silicon nitride layer is removed to produce the structure shown in Figure 8. The thickness of the recessed oxide region is from about $6 \times 10^{-7}$ m to $7 \times 10^{-7}$ m (6,000 to 7,000 Angstroms). This recessed oxide region 40 encircles a region of monocrystalline silicon wherein it is desired to form an integrated circuit device which is isolated from others. The silicon dioxide layer 36 is completely removed at this point and the structure is then subjected to a thermal oxidation using an ambient of oxygen, hydrogen chloride and steam at a temperature of about 800°C to form the desired gate silicon dioxide layer 42 (Figure 9) for the FET gate structure. This thermal oxidation process produces high quality silicon dioxide.

Referring now to Figure 9, a layer 44 of polycrystalline silicon is now deposited over the entire surface of the silicon substrate 10 including layers 40 and 42 by chemical vapour deposition, using silane in the temperature range 600°C to 1000°C. The polycrystalline silicon layer 44 is then doped with an N-type impurity such as phosphorous by thermal diffusion or ion implantation. Alternatively, the doping of the polycrystalline silicon layer 44 may be simultaneous with its deposition. The preferred thickness of the polycrystalline silicon layer is between about $3\times10^{-7}$ m and $5\times10^{-7}$ m (3,000 and 5,000 Angstroms) and the preferred doping level is between about $10^{19}$ to $10^{-21}$ atoms/cm$^3$.

Next, a layer of resist material (not shown) is deposited over the polycrystalline silicon layer 44. Standard lithographic and masking techniques are utilised to provide a mask structure in the resist layer in the area where a polycrystalline silicon gate electrode is desired. The resist layer is then used as a mask for the selective etching of the polycrystalline silicon layer 44 so as to form the gate electrode. This etching is accomplished by directional or anisotropic reactive ion etching in a carbon tetrafluoride-hydrogen atmosphere.

At this point it.is conventional in the prior art to remove the silicon dioxide layer by a chemcial wet etch in areas wherein it is desired to either ion implant or diffuse source and drain regions. During this etching process, portions of the silicon dioxide layer under the edges of the polycrystalline silicon gate electrode are also removed. The surface of the silicon substrate is then reoxidized by conventional thermal oxidation techniques to form a silicon dioxide layer over the source and drain regions. During this oxidation process, silicon dioxide of lower quality than the gate silicon dioxide layer is formed underneath the edges of the polycrystalline silicon gate electrodes. In addition, the edges of the polycrystalline silicon gate electrodes are found to be lifted by this oxidation process. These problems adversely affect the electrical characteristics of field effect transistor integrated circuit structures.

One possible solution for these problems has been described in the above-mentioned U.S. Patent 4,287,661, Figure 4, wherein the reactive ion etching of the polycrystalline silicon layer in the unmasked areas is stopped when a thickness of polycrystalline silicon of the order to 500 Angstroms remains on the silicon dioxide layer. The resist layer is then removed and the structure is subjected to a thermal oxidation to convert the polycrystalline silicon in the unmasked areas to silicon dioxide. The sidewall of the polycrystalline silicon gate electrode is also converted to silicon dioxide during this oxidation process. The silicon dioxide layers are then etched anisotropically by a reactive ion etching process down to the silicon substrate in regions where the source and drains are to be formed. Therefore, since no oxidation will occur at the gate/silicon dioxide edges during subsequent oxidation, the quality of the gate silicon dioxide layer is maintained at a high level. However, the problem with this method of fabrication is that the dimensions of the polycrystalline silicon gate electrode and the channel length of FET's cannot be precisely controlled, resulting in adverse effects on the electrical characteristics of FET integrated circuit structures.

In accordance with the present technique, and referring back to Figure 9, the resist layer is removed following the reactive ion etching of the polycrystalline silicon layer 44 to form the gate electrode. Thereafter, a silicon dioxide layer 46 of between about 100 to 220 nm (1,000 and 2,000 Angstroms) is deposited over the entire surface of the silicon substrate 10 by chemical vapour deposition, utilising an ambient of dichorosilane and nitrogen oxide at a temperature of about 900°C.

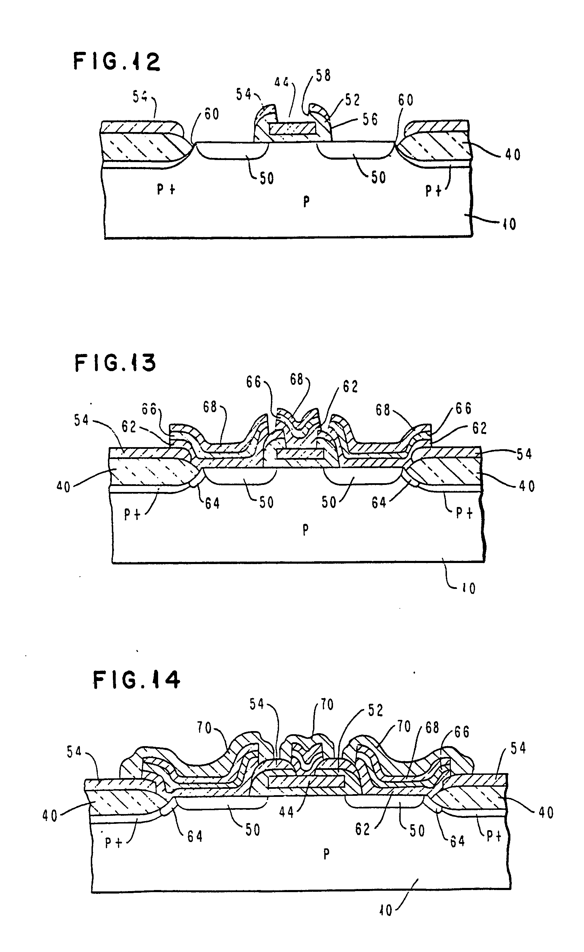

Referring now to Figure 10, the layers 42 and 46 are etched anisotropically by a reactive ion etching process down to the surface of the silicon substrate 10 in the desired source and drain regions. In the preferred embodiment illustrated in Figure 10, the reactive ion etching for layers 42 and 46 utilises the following parameters: A carbon tetrafluoride-hydrogen atmosphere, an RF parallel plate structure, about 30 microns pressure, 0.27 watts/cm$^2$ power density, 7 cc/minute flow rate for hydrogen, and 13 cc/minute flow rate for carbon tetrafluoride. During this etching process, the horizontal silicon dioxide layers 42 and 46 are removed, leaving the regions of the silicon dioxide layer 46 on the vertical sidewall regions of the polycrystalline silicon gate electrode 44 substantially intact. this then shields the gate silicon dioxide under the edges of the gate electrode during subsequent oxidation, this maintaining the quality of the gate silicon dioxide 42 at a high level and provides significant improvement in controlling the dimensions of the gate electrode.

Referring to Figure 11, an N-type impurity such as arsenic is introduced into the silicon substrate 10 by ion implantation and a subsequent drive-in process to form the source and drain N+ regions 50. The structure is then subjected to another thermal oxidation step utilising an ambient of oxygen, hydrogen chloride and steam at a temperature of about 1000°C to form a substantially high quality silicon dioxide layer 52 and also serve as the drive-in process. This is then followed by the deposition of silicon dioxide layer 54 by chemical vapour deposition. The combined thicknesses of the silicon dioxide layers 52 and 54 is of the order of 500 nm (5,000 Angstroms). Figure 11 shows the resulting structure.

The next step in the process, shown in Figure 12, comprises forming contact windows 56 and 58 in the silicon dioxide layers 52 and 54 to define contact areas for the source and drain N+ regions 50 and the polycrystalline silicon gate electrode 44 respectively. The contact windows 56 and 58 are formed in accordance with well-known resist, lithography and etching techniques. As a result of mask misalignment and overetching of the silicon dioxide layers 52 and 54 during the formation of the contact windows, the contact windows are not aligned with the source and drain N+ regions 50. Furthermore, a portion of the recessed silicon dioxide 40 is also removed during the etching of the silicon dioxide layers 52 and 54 to form the contact windows. Therefore, at least portions 60 of the P-type silicon substrate 10 are exposed by the contact windows, as shown in Figure 12.

Referring now to Figure 13, a polycrystalline silicon layer 62 is deposited over the entire surface of the silicon substrate 10 and into contact windows 56 and 58 to interface with the exposed portions 60 of the P-type silicon substrate 10 by chemical vapour deposition. The preferred thickness of the polycrystalline silicon layer 62 is from about $3 \times 10^{-7}$ and $5 \times 10^{-7}$ m (3,000 to 5,000 Angstroms). The polycrystalline silicon layer 62 is then doped with an N-type impurity such as phosphorous by thermal diffusion or ion implantation. During this latter step, the phosphorous dopants diffuse into the polycrystalline silicon layer 62 and are doped into the P-type silicon substrate 10 through the contact windows 56, resulting in the formation of N+ regions 64 under the contact windows 56. Consequently, shortcircuiting of the PN junction by the subsequent metal layers to be deposited does not take place. A layer 66 of a refractory metal alloy such as titanium/tungsten comprising 10 to 30 percent by weight tungsten and having a thickness of between about $5 \times 10^{-8}$ m and $2 \times 10^{-7}$ m (500 and 2,000 Angstroms) is then deposited over the polycrystalline silicon layer 62, preferably by RF sputtering. A top layer 66 is deposited a second layer 68 of another refractory metal or metal alloy such as tantalum, tungsten or titanium/tungsten comprising at least 70 percent tungsten, preferably by RF sputtering. However, tantalum, if used, may be deposited by evaporation. The preferred thickness of layer 68 is between about $5 \times 10^{-8}$ m and $2 \times 10^{-7}$ m (500 and 2,000 Angstroms). A layer of a resist material (not shown) is then deposited over layer 68 and standard lithographic and masking techniques are utilised to provide a mask structure in the resist layer in areas lying directly above and slightly overlapping contact windows 56 and 58 where layers 62, 66 and 68 are desired. Layers 62, 66 and 68 are removed using the resist layer as the mask, in undesired areas by suitable etching techniques. The resist layer (not shown) is then removed using conventional techniques.

Referring now to Figure 14, the next step of processing includes depositing a second layer of another resist material (not shown) which may be dissolved in n-methyl pyrolidone solution over the entire surface of the silicon substrate 10 including layers 54 and 68. Standard lithographic and masking techniques are then utilised to provide another mask structure in the second resist layer in areas where a layer of interconnect metal is not desired. A layer 70 of interconnect metal such as aluminium is then deposited over the surface of the silicon substrate including layer 68 as well as the remaining resist layer (not shown) by evaporation. Thereafter, the portions of the deposited layer 70 on top of the remaining resist layer are removed by dissolving the second resist layer in an n-methyl pyrolidone solution at a temperature of about 85°C leaving an interconnection pattern which forms the conductive interconnection paths between various other devices and regions in the integrated circuit.

The structure is next subjected to a sintering process at a temperature of at least 400°C for a period of 30 minutes to one hour to ensure good electrical connection between the interconnecting aluminium layer and the multilayer contact structure.

## Claims

1. An integrated circuit ohmic contact structure for a shallow semiconductor region (12) provided in the surface of, and forming a PN junction with, a surrounding silicon semiconductor body (10), comprising an insulating layer (16) formed on the surface of the silicon semiconductor body, the insulating layer having a contact window (18) exposing the shallow semiconductor region (12), a polycrystalline silicon layer (22) formed in the contact window (18) and overlapping the edges thereof, the polycrystalline silicon layer (22) being doped with an impurity of the same conductivity type as that of the semiconductor region (12), the structure being characterised by a plurality of layers (26, 28) of refractory metal formed on the polycrystalline silicon layer (22), and a layer (34) of interconnect metal formed on the upper surface of the refractory metal layers.

2. A structure as claimed in Claim 1, wherein the insulating layer (16) comprises silicon dioxide.

3. A structure as claimed in Claim 1 or 2, wherein the thickness of the polycrystalline silicon layer (22) is from 300—500 nm (3,000 to 5,000 Angstroms).

4. A structure as claimed in Claim 3, wherein the doping level of the impurity in the polycrystalline silicon layer (22) is from $10^{19}$ to $10^{21}$ atoms per cubic centimetre.

5. A structure as claimed in any preceding Claim, wherein the plurality of layers of refractory metal comprises a first layer (26) of a titanium/tungsten alloy comprising 10 to 30 percent by weight tungsten.

6. A structure as claimed in Claim 5, wherein the plurality of layers of refractory metal further includes a second layer (28) of tantalum, tungsten or a titanium/tungsten alloy comprising at least 70 percent by weight tungsten.

7. A structure as claimed in Claim 6, wherein the thickness of each of the first and second refractory metal layers is from 500 to 2000 Angstroms.

8. A method of fabricating an integrated circuit field effect transistor wherein a layer of polycrystalvune silicon is formed over a silicon body (10) covered by a first layer of silicon dioxide (42), the polycrystalline silicon layer being selectively etched to form a gate electrode (44), characterised by:

chemically vapour depositing a second layer (46) of silicon dioxide over the gate electrode (44),

reactive ion etching the first and second silicon dioxide layers (42, 46) to remove the silicon dioxide layers where source and drain regions are desired while leaving a portion of silicon dioxide (46) on the vertical sidewalls of the gate electrode (44),

providing source and drain regions (50) adjacent to the gate electrode (44),

forming a third layer (52, 54) of silicon dioxide over the source and drain regions (50) and the electrode (44), the third layer having contact windows (56) exposing the source and drain regions (50), and

providing a respective contact structure to the gate electrode (44) and the source and drain regions (50), the contact structure comprising a polycrystalline silicon layer on the source and drain regions, the polycrystalline layer being doped with an impurity of the same conductivity type as that of the source and drain regions, a plurality of layers of refractory metal on the polycrystalline silicon layer, and a layer of interconnect metal on the refractory metal layers.

9. A method as claimed in claim 8, wherein the thickness of the chemically vapour deposited second layer (46) of silicon dioxide is from 100—200 nm (1,000 to 2,000 Angstroms).

**Patentansprüche**

1. Ohmsche Kontaktstruktur in integrierten Schaltungen für einen flachen Halbleiterbereich (12), der in der Oberfläche eines umliegenden Silizium-Halbleiterkörpers (10) vorgesehen ist und mit diesen einen p—n-Übergang bildet, mit einer auf der Oberfläche des Silizium-Halbleiterkörpers ausgebildeten Isolierschichte (16), die ein den flachen Halbleiterbereich (12) freigebendes Kontaktfenster (18) besitzt, mit einer in dem Kontaktfenster (18) ausgebildeten und dessen Ränder überlappenden polykristallinen Siliziumschichte (22), wobei die polykristalline Siliziumschichte (22) mit Fremdatomen des gleichen Leitungstyps dotiert ist, wie der Halbleiterbereich, dadurch gekennzeichnet, daß auf der polykristallinen Siliziumschichte (22) eine Anzahl von Schichten (26, 28) aus Refraktormetall ausgebildet ist und eine Schichte (34) aus Anschlußmetall auf der oberen Oberfläche der Refraktormetallschichten ausgebildet ist.

2. Struktur nach Anspruch 1, bei welcher Isolierschichte (16) Siliziumdioxid enthält.

3. Struktur nach Anspruch 1 oder 2, bei welcher die Dicke der polykristallinen Siliziumschichte (22) 300 bis 500 nm (3000 bis 5000 Angström) beträgt.

4. Struktur nach Anspruch 3, bei welcher der Dotierungspegel von Fremdatomen in der polykristallinen Siliziumschichte (22) $10^{19}$ bis $10^{21}$ Atome pro Kubikzentimeter beträgt.

5. Struktur nach irgendeinem vorgehenden Anspruch, bei welcher die Anzahl von Schichten aus Refraktormetall eine erste Schichte (26) aus einer Titan-Wolfram-Legierung mit 10 bis 30 Gewichtsprozenten Wolfram aufweist.

6. Struktur nach Anspruch 5, bei welcher die Anzahl von Schichten us Refraktormetall eine zweite Schicht (28) aus Tantal, Wolfram oder aus einer Titan-Wolfram-Legierung mit zumindest 70 Gewichtsprozent Wolfram aufweist.

7. Struktur nach Anspruch 6, bei welcher die Dicke sowohl der ersten als auch der zweiten Refraktormetallschichte (500 bis 2000 Angström beträgt.

8. Verfahren zur Herstellung eines Feldeffekttransistors als integrierte Schaltung, bei welchem eine Schichte aus polykristallinem Silizium auf einem von einer ersten Schichte aus Siliziumdioxid (42) bedeckten Siliziumkörper (10) ausgebildet und die polykristalline Siliziumschichte zur Bildung einer Gateelektrode (44) selektiv geätzt wird, dadurch gekennzeichnet, daß

durch chemische Dampfabscheidung eine zweite Schichte (46) aus Siliziumdioxid über der Gateelektrode (44) gebildet wird,

die erste und zweite Siliziumdioxidschichte (42, 46) durch reaktives Ionenätzen behandelt werden, um dort, wo Source- und Drainbereiche gewünscht sind, die Siliziumdioxidschichten zu entfernen und um hingegen an den vertikalen Seitenwänden der Gateelektrode (44) einen Abschnitt aus Siliziumdioxid (46) zu belassen.

benachbart zu der Gateelektrode (44) Source- und Drainbereiche (50) geschaffen werden,

eine dritte Schichte (52, 54) aus Siliziumdioxid über den Source- und Drainbereichen (50) und der Gateelektrode (44) ausgebildet wird, wobei die dritte Schichte die Source- und Drainbereiche (50) freigebende Kontaktfenster (56) besitzt,

für die Gateelektrode (44) und die Source- und Drainbereiche (50) eine zugehörige Kontaktstruktur vorgesehen wird, wobei die Kontaktstruktur auf den Source- und Drainbereichen eine polykristalline Siliziumschichte, die mit Fremdatomen des gleichen Leitungstyps dotiert ist, wie die Source- und Drainbereiche, eine Anzahl von Schichten aus Refraktormetall auf der polykristallinen Siliziumschichte sowie eine Schichte aus Anschlußmetall auf den Refraktormetallschichten aufweist.

9. Verfahren nach Anspruch 8, bei welchem die Dicke der durch chemische Dampfabscheidung hergestellten zweiten Schichte (46) aus Siliziumdioxid 100—200 nm (1000 bis 2000 Angström) beträgt.

**Revendications**

1. Structure de contact ohmique de circuit intégré pour une région semi-conductrice peu profonde (12) prévue dans la surface d'un corps semi-conducteur en silicium environnant (10) et formant une jonction PN avec ce corps, comprenant une couche isolante (16) formée sur la surface du corps semi-conducteur en silicium, la couche isolante comportant une fenêtre de contact (18) qui découvre la région semi-conductrice peu profonde (12), une couche de silicium polycristallin (22) formée dans la fenêtre de contact (18) et chevauchant les bords de celle-ci, la couche de silicium polycristallin (22) étant dopée avec une impureté du même type de conductivité qui celui de la région semi-conductrice (12), la structure étant caractérisée par une pluralité de couches (26, 28) de métal réfractaire, formées sur la couche de silicium polycristallin (22), et une couche (34) de métal d'interconnexion formée sur la surface supérieure des couches de métal réfractaire.

2. Structure suivant la revendication 1, dans laquelle la couche isolante (16) est du dioxyde de silicium.

3. Structure suivant la revendication 1 ou 2, dans laquelle l'épaisseur de la couche de silicium polycristallin (22) et des 300 à 500 nm.

4. Structure suivant la revendication 3, dans laquelle le niveau de dopage de l'impureté dans la couche de silicium polycristallin (22) est de $10^{19}$ à $10^{21}$ atomes/cm$^3$.

5. Structure suivant l'une quelconque des revendications précédentes, dans laquelle la pluralité de couches de métal réfractaire comprend une première couche (26) d'un alliage de titanetungstène contenant 10 à 30% en poids de tungstène.

6. Structure suivant la revendication 5, dans laquelle la pluralité de couches de métal réfractaire comprend en outre une deuxième couche (28) de tantale, de tungstène ou d'un alliage de titane/tungstène contenant au moins 70% en poids de tungstène.

7. Structure suivant la revendication 6, dans laquelle l'épaisseur de chacune des première et deuxième couches de métal réfractaire est de 50 à 200 nm.

8. Procédé de fabrication d'un transistor à effet de champ de circuit intégré, dans lequel une couche de silicium polycristallin est formée sur un corps de silicium (10) recouvert d'une première couche de dioxyde de silicium (42), la couche de silicium polycristallin étant attaquée sélectivement pour former une électrode de grille (44), caractérisé par les opérations de:

dépôt chimique en phase vapeur d'une deuxième couche (46) de dioxyde de silicium sur l'électrode de grille (44),

attaque par ions réactifs des première et deuxième couches de dioxyde de silicium (42, 46) pour éliminer les couches de dioxyde de silicum aux endroits où on désire former les régions de source et de drain, tout en laissant une portion de dioxyde de silicium (46) sur les parois latérales verticales de l'électrode de grille (44),

formation de régions (50) de source et de drain adjacentes à l'électrode de grille (44),

formation d'une troisième couche (52, 54) de dioxyde de silicium sur les régions de source et de drain (50) et l'électrode de grille (44), la troisième couche comportant des fenêtres de contact (56) qui découvrent les régions de source et de drain (50), et

application d'une structure de contact respective à l'électrode de grille (44) et aux régions de source et de drain (50), la structure de contact comprenant une couche de silicium polycristallin sur les régions de source et de drain, la couche polycristalline étant dopée avec une impureté du même type de conductivité que celui des régions de source et de drain, une pluralité de couches de métal réfractaire sur la couche de silicium polycristallin, et une couche de métal d'interconnexion sur les couches de métal réfractaire.

9. Procédé suivant la revendication 8, dans lequel l'épaisseur de la deuxième couche de dépôt chimique en phase vapeur (46) de dioxyde de silicium est de 100 à 200 nm.

FIG. 1

FIG. 2

FIG. 3

FIG. 4

FIG. 5

FIG. 6

FIG. 7

FIG.8

FIG.9

FIG.10

FIG.11

FIG.12

FIG.13

FIG.14